# EUROPÄISCHE PATENTSCHRIFT

(11) **EP 2 469 288 B1**
(45) Veröffentlichungstag und Bekanntmachung des Hinweises auf die Patenterteilung: **18.03.2015**
(21) Anmeldenummer: 11192915.4
(22) Anmeldetag: 12.12.2011
(51) Int. Cl.: G01R 31/36, G01D 7/02, G01D 7/04, G01D 7/10, G01D 7/00, G01D 7/06, G01D 13/00

(54) **Elektrokraftfahrzeug mit einer Anzeigevorrichtung**
Electric vehicle with a display device
Véhicule électrique doté d'un dispositif d'affichage

(30) Priorität: 23.12.2010 DE 102010055797
(43) Veröffentlichungstag der Anmeldung: 27.06.2012
(73) Patentinhaber: Continental Automotive GmbH, 30165 Hannover (DE)
(72) Erfinder: Grundmann, Holmer-Geert, 64832 Babenhausen (DE); Lüttringhaus, Hannes, 63477 Maintal (DE); Schreiner, Otmar, 64347 Griesheim (DE)

(56) Entgegenhaltungen:
- WO-A2-2010/130743
- GB-A- 2 466 561
- US-A- 4 210 908
- US-A- 5 539 399
- US-A1- 2003 137 278
- US-A1- 2010 106 353
- US-A1- 2010 277 495

## Beschreibung

Die Erfindung bezieht sich auf ein Elektrokraftfahrzeug mit einem Elektroantriebsmotor, mit einem Akkumulator zum Speichern elektrischer Energie für den Betrieb des Elektroantriebsmotors, mit einer eine Mehrzahl von einzeln ansteuerbaren Leuchtsegmenten aufweisenden optischen Anzeigevorrichtung und mit einem Anzeigesteuergerät.

Aus Druckschrift DE 10 2009 060 313 A1 ist ein Elektrofahrzeug, welches durch Betreiben eines Motors unter Verwendung einer Batterie als Leistungsquelle angetrieben wird, mit einer Ladeanzeigevorrichtung bekannt, wobei die Ladeanzeigevorrichtung eine Messgeräteanordnung, die zum Anzeigen einer Geschwindigkeit des Elektrofahrzeugs imstande ist, und eine Ladezustandsanzeigeeinrichtung, welche an der Messgeräteanordnung vorgesehen ist und welche konfiguriert ist, einen Ladezustand der Batterie anzuzeigen, aufweist.

Weiterhin ist aus Druckschrift US 5,757,595 A eine Vorrichtung zur Anzeige des Ladens einer Batterie eines Elektrofahrzeugs bekannt, wobei eine Anzeigetafel mit einer Ziffernanzeige zur Anzeige des Ladezustands der Batterie neben einem Ladeanschluss an einer Außenseite des Elektrofahrzeugs angeordnet ist.

US 2010/106353 A1, WO 2010/130743 A2, US 5 539 399, US 2010/277495 A1, US 2003/137278 A1, US 4 210 908 zeigen verschiedene Anzeigen für Kraftfahrzeuge.

Ausgehend vom Stand der Technik liegt der Erfindung die Aufgabe zugrunde, ein Elektrokraftfahrzeug der eingangs genannten Art zu schaffen, für das wichtige Fahrzeuginformationen mittels der Anzeigevorrichtung besonders leicht und zuverlässig erfassbar darstellbar sind.

Diese Aufgabe wird erfindungsgemäß gelöst mit einem Elektrokraftfahrzeug der eingangs genannten Art, wobei die Leuchtsegmente ein mindestens zweidimensionales Leuchtsegmentfeld bildend und Licht in vertikaler Richtung nach oben abstrahlend angeordnet sind und wobei das Anzeigesteuergerät ausgebildet ist, die Leuchtsegmente des Leuchtsegmentfeldes derart anzusteuern, dass das Leuchtsegmentfeld eine nicht-digitale Akkumulatorladezustandsinformation und/oder eine nicht-digitale Fahrzeugbetriebszustandsinformation abgibt.

Von besonderem Vorteil bei der Erfindung ist zum einen das Vorsehen des Leuchtsegmentfeldes und somit einer flächigen, leicht erfassbaren und eine erhebliche Aufmerksamkeitswirkung im Anzeigefall entfaltenden Leuchteinrichtung sowie zum anderen die Anordnung der Leuchtsegmente in einer Weise, dass diese Licht in vertikaler Richtung nach oben abstrahlen, das heißt die Leuchtsegmente strahlen Licht in Richtung der Fahrzeughochachse nach oben ab. Damit sind das Leuchtsegmentfeld, welches Leuchtsegmentfeld fahrzeugintern sowie fahrzeugfest angeordnet ist, und die von diesem abgegebene Information nicht nur innerhalb des Elektrofahrzeugs sehr gut erkennbar, was insbesondere bei fahrendem oder Fahrt aufnehmendem Elektrofahrzeug besonders vorteilhaft ist, sondern auch von außerhalb des Elektrofahrzeugs kann ohne Änderung an der Anzeigevorrichtung eine sehr gute Erfassung der von dem Leuchtsegmentfeld abgegebenen Information erfolgen, was insbesondere bei stehendem Elektrofahrzeug, vor allem während eines Ladevorgangs des Akkumulators, von besonderem Vorteil ist.

Gegenüber einer (gegebenenfalls auch gebogenen oder gekrümmten) Balkenanzeige wird mit der Erfindung durch das Vorsehen eines Leuchtsegmentfeldes, also einer flächigen Leuchteinrichtung, die Aufmerksamkeitswirkung der Informationsabgabe wesentlich erhöht. Der Fahrer des Elektrokraftfahrzeugs kann die Anzeige zum Beispiel als pulsierenden Lichtfleck wahrnehmen. Die sehr leichte Erfassbarkeit der abgegebenen Information wird zudem besonders unterstützt durch die erfindungsgemäß nicht-digitale Informationsabgabe, die somit auf eine Ziffernanzeige vollständig verzichtet. Das Leuchtsegmentfeld kann eben ausgeführt sein; es ist aber zum Beispiel auch eine gewölbte oder kuppelförmige Ausbildung des Leuchtsegmentfeldes denkbar, wodurch das Leuchtsegmentfeld eine dreidimensionale Gestaltung erhält.

Ein wichtiger Vorteil der Erfindung liegt darin, dem Fahrer des Elektrokraftfahrzeugs die besonders wichtigen Informationen Akkumulatorladezustandsinformation und/oder Fahrzeugbetriebszustandsinformation auf nachhaltige Weise sensorisch erfahrbar zu machen, ohne den Fahrer mit technischen Details, wie zum Beispiel einer Anzeige von exakten Messwerten, zu überfrachten. Die Anzeige der Information erfolgt im Grundsatz qualitativ. Auch muss die Anzeige, nämlich im einzelnen das Leuchtsegmentfeld, nicht im direkten Sichtfeld des Fahrers des Elektrokraftfahrzeugs angeordnet sein. Ein Erkennen der Anzeige im peripheren Sichtfeld des Fahrers ist ausreichend und sogar gewünscht, um nicht unnötig Gefahr zu laufen, den Fahrer möglicherweise vom Verkehrsgeschehen abzulenken. Mit der Erfindung können zum Beispiel Momentanverbrauch, das heißt die momentane elektrische Leistungsaufnahme, und/oder das momentane Leistungsvermögen des Elektrokraftfahrzeugs qualitativ angezeigt werden.

Besonders vorteilhaft ist es, dass mit der Erfindung ein durch das Leuchtsegmentfeld gebildetes deutlich sichtbares Anzeigeelement eine Betriebsbereitschaft des Elektrokraftfahrzeuges durch Aufleuchten einfach anzeigen kann. Ein solches, die nicht-digitale Fahrzeugbetriebszustandsinformation abgebendes Aufleuchten kann beispielsweise zeitlichen und/oder räumlichen (das heißt es leuchten nicht immer alle oder nicht immer dieselben Leuchtsegmente des Leuchtsegmentfeldes auf) und/oder farblichen Veränderungen unterliegen, welche Veränderungen vorzugsweise in einem unmittelbaren Bezug zu einem momentanen Betriebszustand des Elektrokraftfahrzeugs stehen. Solches kann beispielsweise durch Auswerten jeweils aktueller Werte einer Fahrzeugsensorik und/oder von jeweils aktuellen Leistungsdaten, zum Beispiel Geschwindigkeit und/oder Energieaufnahme und/oder ausgewählter Betriebsmodus, erfolgen. Mit der Erfindung ist es zum Beispiel nicht erforderlich, in dem Elektrokraftfahrzeug künstlich ein Motorgeräusch zu erzeugen, um dem Fahrer einen Hinweis auf die Betriebsbereitschaft des Fahrzeuges zu geben.

Im Zusammenhang mit einem Aufladen des Akkumulators ist es mit der Erfindung von Vorteil, dass das durch das Leuchtsegmentfeld gebildete deutlich sichtbare Anzeigeelement einen aktuellen Ladevorgang durch Aufleuchten in einfacher, aber wirkungsvoller Weise anzeigen kann. Auch ein solches, die nicht-digitale Akkumulatorladezustandsinformation abgebendes Aufleuchten kann beispielsweise zeitlichen und/oder räumlichen (das heißt es leuchten nicht immer alle oder nicht immer dieselben Leuchtsegmente des Leuchtsegmentfeldes auf) und/oder farblichen Veränderungen unterliegen, welche Veränderungen vorzugsweise in einem unmittelbaren Bezug zu einem momentanen Ladezustand des Akkumulators des Elektrokraftfahrzeugs stehen. Solches kann beispielsweise durch Auswerten jeweils aktueller Werte einer Fahrzeugsensorik und/oder von jeweils aktuellen Leistungsdaten, zum Beispiel Akkumulatorladezustand und/oder Energiemenge und/oder ausgewählter Auflademodus, erfolgen.

Man könnte sich vorstellen, dass das Leuchtsegmentfeld eine plan- und regellose Anordnung von Leuchtsegmenten aufweist. Gemäß einer vorteilhaften Weiterbildung der Erfindung weist das Leuchtsegmentfeld hingegen die Form einer Matrix auf. Die Leuchtsegmente des Leuchtsegmentfeldes sind damit also matrixförmig angeordnet, das heißt die Leuchtsegmente sind nach einem geordneten Schema angeordnet. Dadurch ist eine besonders differenzierte Informationsabgabe mit dem Leuchtsegmentfeld möglich.

Es ist zum Beispiel denkbar, dass das Leuchtsegmentfeld an einer Mittelkonsole zwischen einem Fahrer- und einem Beifahrersitz des Elektrokraftfahrzeugs angeordnet ist. Für eine sowohl im Fahrzeuginnenraum des Elektrokraftfahrzeugs als auch von der Außenseite des Fahrzeugs her besonders gute Erfassbarkeit der mit dem Leuchtsegmentfeld abgegebenen Informationen ist es hingegen von Vorteil, wenn gemäß der Erfindung das Leuchtsegmentfeld an einer Armaturentafel des Elektrokraftfahrzeugs angeordnet ist. Gemäß der Erfindung ist das Leuchtsegmentfeld in der Mitte der Armaturentafel bezogen auf die Fahrzeugbreite angeordnet.

Grundsätzlich könnte man sich vorstellen, dass das Leuchtsegmentfeld unter einem Deckglas oder einer Folie angeordnet ist. Für einen Schutz des Leuchtsegmentfeldes nicht nur vor mechanischer Beschädigung, sondern vor allem auch für eine Erhöhung der Aufmerksamkeitswirkung und verbesserte Wahrnehmbarkeit von mit dem Leuchtsegmentfeld abgegebenen Informationen ist es von besonderem Vorteil, wenn gemäß einer anderen Weiterbildung der Erfindung eine das Leuchtsegmentfeld übergreifende, von den Leuchtsegmenten durchleuchtbare kuppelförmige Leuchtsegmentfeldabdeckung vorgesehen ist.

Eine andere Weiterbildung der Erfindung sieht vor, dass die Leuchtsegmente des Leuchtsegmentfeldes von jeweils einer Leuchteinheit gebildet werden, wobei die Leuchteinheiten ausgebildet sind, jeweils in unterschiedlichen Farben zu leuchten. Damit kann vorteilhaft eine besonders differenzierte Informationsabgabe des Leuchtsegmentfeldes erfolgen. Eine Leuchtanzeige durch das Leuchtsegmentfeld wird dabei mittels mehrfarbigen, vorzugsweise matrixförmig angeordneten, Leuchteinheiten, die jeweils ein Leuchtsegment bilden, bewirkt. Die Leuchteinheiten können zum Beispiel RGB-LEDs sein oder in OLED- oder TFT-Technik aufgebaut sein.

Gemäß einer anderen vorteilhaften Weiterbildung der Erfindung sind eine mit dem Anzeigesteuergerät verbundene Sendeeinheit und ein mobiles Anzeigegerät vorgesehen, wobei die Sendeeinheit zu einer drahtlosen Ankoppelung des Anzeigegerätes und das Anzeigegerät zu einer Anzeige der Akkumulatorladezustandsinformation und/oder der Fahrzeugbetriebszustandsinformation ausgebildet ist. Mit dieser Weiterbildung kann zum Beispiel ein das mobile Anzeigegerät mitführender Fahrer des Elektrokraftfahrzeugs während der Dauer des Aufladens des Akkumulators andere Erledigungen tätigen und gleichzeitig über das mitgeführte mobile Anzeigegerät über den Ladevorgang informiert bleiben. Die jeweilige Information wird vorzugsweise sowohl mit dem (fahrzeuginternen sowie fahrzeugfesten) Leuchtsegmentfeld als auch mit dem mobilen Anzeigegerät abgegeben; in jedem Fall wird die Information jedoch zumindest mit dem (fahrzeuginternen sowie fahrzeugfesten) Leuchtsegmentfeld abgegeben. Das mobile Anzeigegerät kann zum Beispiel ein Smart-Phone oder ein Fahrzeugschlüssel sein.

Alternativ ist es auch denkbar, dass nicht ein mobiles Anzeigegerät, sondern ein immobiles, aber nicht am Fahrzeug angeordnetes, fahrzeugexternes Anzeigegerät genutzt wird, wie zum Beispiel ein in eine Ladestation für das Elektrokraftfahrzeug integriertes Anzeigegerät; in diesem Fall könnte eine Ankoppelung des Anzeigegerätes an die Sendeeinheit drahtlos oder mittels eines Elektrokabels erfolgen.

Von besonderem Vorteil für eine zuverlässige und einfach erfassbare Information des Fahrers des Elektrokraftfahrzeugs über die zum jeweiligen Zeitpunkt geltende Längsfahrtrichtungswahl ist es, wenn gemäß einer anderen Weiterbildung der Erfindung das Anzeigesteuergerät ausgebildet ist, die Leuchtsegmente derart anzusteuern, dass das Leuchtsegmentfeld eine Längsfahrtrichtungswahl für das Elektrokraftfahrzeug als Fahrzeugbetriebszustandsinformation anzeigt. Der besondere Vorteil besteht für den Fahrer dabei zum einen in einer Anzeige, dass das Elektrokraftfahrzeug grundsätzlich fahrbereit ist (das heißt eine Betätigung eines Fahrpedals des Elektrokraftfahrzeugs führt zu einer Fahrzeugbewegung) sowie auch einer Kenntnis über die zu erwartende Bewegungsrichtung (vorwärts oder rückwärts). Die Längsfahrtrichtungswahl kann zum Beispiel durch eine richtungsabhängige Aufwärts- oder Abwärtsbewegung eines durch Aufleuchten eines Leuchtsegmentes erzeugten Lichtpunktes in dem Leuchtsegmentfeld angezeigt werden.

Einer anderen vorteilhaften Weiterbildung der Erfindung entsprechend ist das Anzeigesteuergerät ausgebildet, die Leuchtsegmente derart anzusteuern, dass das Leuchtsegmentfeld einen laufenden Aufladevorgang des Akkumulators als Akkumulatorladezustandsinformation anzeigt. Die besonders wichtige Information über den Fortschritt eines Aufladevorgangs ist dem Fahrer des Elektrokraftfahrzeugs so - unabhängig davon, ob er sich innerhalb des Elektrokraftfahrzeugs oder außerhalb des Elektrokraftfahrzeugs befindet - stets zuverlässig und leicht erkennbar übermittelbar.

Ein Ausführungsbeispiel der Erfindung ist in der Zeichnung dargestellt und wird im Folgenden näher beschrieben. Es zeigen:
- Figur 1: ein Elektrokraftfahrzeug in schematisierter Darstellung und
- Figur 2: in schematisierter Darstellung einen Ausschnitt aus dem Elektrokraftfahrzeug nach Figur 1 mit einem Leuchtsegmentfeld.

Sich entsprechende Elemente sind in allen Figuren mit jeweils gleichen Bezugszeichen versehen.

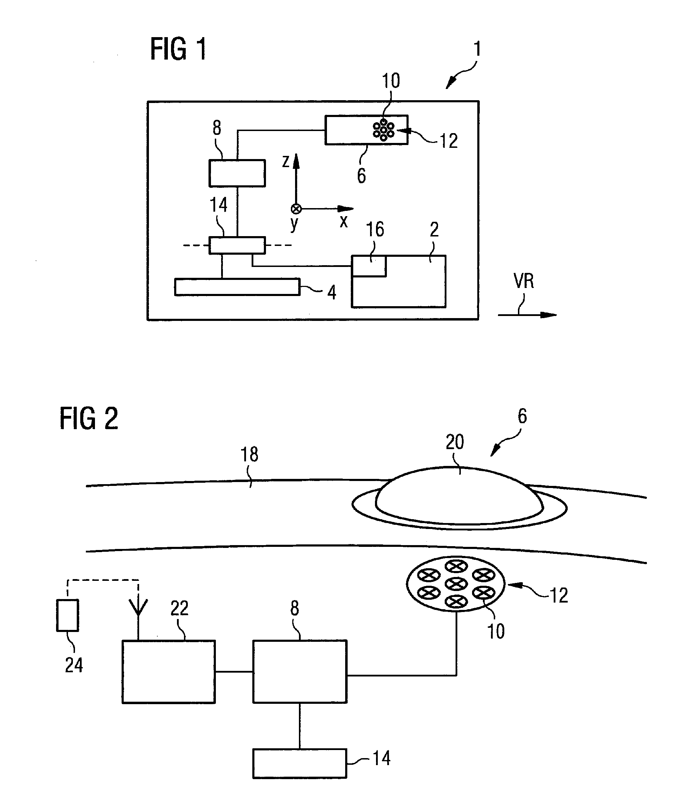

In Figur 1 ist ein Elektrokraftfahrzeug 1 mit einem Elektroantriebsmotor 2 und einem Akkumulator 4 zum Speichern elektrischer Energie für den Betrieb des Elektroantriebsmotors 2 gezeigt. Ein Pfeil VR gibt die Vorwärtsfahrtrichtung des Elektrokraftfahrzeugs 1 an. Außerdem ist ein Fahrzeugkoordinatensystem eingezeichnet, wobei die x-Achse des Fahrzeugkoordinatensystems in Vorwärtsfahrtrichtung weist, die y-Achse bezogen auf die Vorwärtsfahrtrichtung nach links und die z-Achse die Fahrzeughochachse angibt und in vertikaler Richtung nach oben weist.

Eine optische Anzeigevorrichtung 6 (siehe auch Figur 2) ist mit einem Anzeigesteuergerät 8 verbunden. Die optische Anzeigevorrichtung 6 weist eine Mehrzahl von Leuchtsegmenten 10 auf, welche ein zweidimensionales Leuchtsegmentfeld 12 bilden. Mittels des Anzeigesteuergerätes 8 sind die Leuchtsegmente 10 des Leuchtsegmentfeldes 12 einzeln ansteuerbar. Über einen Fahrzeugbus 14 ist das Anzeigesteuergerät 8 auch mit dem Akkumulator 4 und einem Motorelektroniksteuergerät 16 des Elektroantriebsmotors 2 verbunden.

Weiterhin ist in Figur 2, die einen vergrößerten Ausschnitt aus dem Elektrokraftfahrzeug 1 nach Figur 1 zeigt, erkennbar, dass das Leuchtsegmentfeld 12 der optischen Anzeigevorrichtung 6 an einer Armaturentafel 18 des Elektrokraftfahrzeugs angeordnet ist. Das Leuchtsegmentfeld 12 weist die Form einer Matrix auf, das heißt die Leuchtsegmente 10 des Leuchtsegmentfeldes 12 sind nach einem geordneten Schema angeordnet. Die Anzeigevorrichtung 6 weist außerdem eine das Leuchtsegmentfeld 12 übergreifende, von den Leuchtsegmenten 10 durchleuchtbare kuppelförmige Leuchtsegmentfeldabdeckung 20 auf. Das Anzeigesteuergerät 8 ist ausgebildet, die Leuchtsegmente 10 des Leuchtsegmentfeldes 12 derart anzusteuern, dass das Leuchtsegmentfeld 12 eine nicht-digitale Akkumulatorladezustandsinformation und/oder eine nicht digitale Fahrzeugbetriebszustandsinformation abgibt.

Ferner sind in dem Elektrokraftfahrzeug eine mit dem Anzeigesteuergerät 8 verbundene Sendeeinheit 22 und ein mobiles, aus dem Elektrokraftfahrzeug entnehmbares Anzeigegerät 24 vorhanden, wobei die Sendeeinheit 22 zu einer drahtlosen Ankoppelung des Anzeigegerätes 24 und das Anzeigegerät 24 zu einer Anzeige der Akkumulatorladezustandsinformation und/oder der Fahrzeugbetriebszustandsinformation ausgebildet ist. Die drahtlose Ankoppelung des Anzeigegerätes 24 an die Sendeeinheit 22 und somit an das Anzeigesteuergerät 8 ist unabhängig davon möglich, ob sich das Anzeigegerät 24 in dem Elektrokraftfahrzeug oder außerhalb desselben befindet.

## Patentansprüche

1. Elektrokraftfahrzeug mit einem Elektroantriebsmotor, mit einem Akkumulator zum Speichern elektrischer Energie für den Betrieb des Elektroantriebsmotors, mit einer eine Mehrzahl von einzeln ansteuerbaren Leuchtsegmenten aufweisenden optischen Anzeigevorrichtung und mit einem Anzeigesteuergerät, **dadurch gekennzeichnet, dass** die Leuchtsegmente (10) ein mindestens zweidimensionales Leuchtsegmentfeld (12) bildend und Licht in vertikaler Richtung nach oben abstrahlen angeordnet sind, wobei das Leuchtsegmentfeld (12) in der Mitte einer Armaturentafel (18) des Elektrokraftfahrzeugs (1) bezogen auf die Fahrzeugbreite angeordnet ist, und dass das Anzeigesteuergerät (8) ausgebildet ist, die Leuchtsegmente (10) des Leuchtsegmentfeldes (12) derart anzusteuern, dass das Leuchtsegmentfeld (12) eine nicht-digitale Akkumulatorladezustandsinformation und/oder eine nicht-digitale Fahrzeugbetriebszustandsinformation abgibt.

2. Elektrokraftfahrzeug nach Anspruch 1, **dadurch gekennzeichne**t, **dass** das Leuchtsegmentfeld (12) die Form einer Matrix aufweist.

3. Elektrokraftfahrzeug nach einem der vorhergehenden Ansprüche, **dadurch gekennzeichnet, dass** eine das Leuchtsegmentfeld (12) übergreifende, von den Leuchtsegmenten (10) durchleuchtbare kuppelförmige Leuchtsegmentfeldabdeckung (20) vorgesehen ist.

4. Elektrokraftfahrzeug nach einem der vorhergehenden Ansprüche, **dadurch gekennzeichnet, dass** die Leuchtsegmente (10) des Leuchtsegmentfeldes (12) von jeweils einer Leuchteinheit gebildet werden, wobei die Leuchteinheiten ausgebildet sind, jeweils in unterschiedlichen Farben zu leuchten.

5. Elektrokraftfahrzeug nach einem der vorhergehenden Ansprüche, **dadurch gekennzeichnet, dass** eine mit dem Anzeigesteuergerät (8) verbundene Sendeeinheit (22) und ein mobiles Anzeigegerät (24) vorgesehen sind, wobei die Sendeeinheit (22) zu einer drahtlosen Ankoppelung des Anzeigegerätes (24) und das Anzeigegerät (24) zu einer Anzeige der Akkumulatorladezustandsinformation und/oder der Fahrzeugbetriebszustandsinformation ausgebildet ist.

6. Elektrokraftfahrzeug nach einem der vorhergehenden Ansprüche, **dadurch gekennzeichnet, dass** das Anzeigesteuergerät (8) ausgebildet ist, die Leuchtsegmente (10) derart anzusteuern, dass das Leuchtsegmentfeld (12) eine Längsfahrtrichtungswahl für das Elektrokraftfahrzeug (1) als Fahrzeugbetriebszustandsinformation anzeigt.

7. Elektrokraftfahrzeug nach einem der vorhergehenden Ansprüche, **dadurch gekennzeichnet, dass** das Anzeigesteuergerät (8) ausgebildet ist, die Leuchtsegmente (10) derart anzusteuern, dass das Leuchtsegmentfeld (12) einen laufenden Aufladevorgang des Akkumulators (4) als Akkumulatorladezustandsinformation anzeigt.

## Claims

1. Electric motor vehicle with an electric drive motor, with an accumulator for storing electrical energy for operating the electric drive motor, with an optical display device having a multiplicity of individually actuable lighting segments, and with a display control device, **characterized in that** the lighting segments (10) are arranged in such a way that they form an at least two-dimensional lighting segment field (12) and irradiate light upward in the vertical direction, wherein the lighting segment field (12) is arranged in the centre of a dashboard (18) of the electric motor vehicle (1) with respect to the width of the vehicle, and **in that** the display control device (8) is designed to actuate the lighting segments (10) of the lighting segment field (12) in such a way that the lighting segment field (12) outputs a nondigital accumulator charge state information item and/or a nondigital vehicle operating state information item.

2. Electric motor vehicle according to Claim 1, **characterized in that** the lighting segment field (12) is in the form of a matrix.

3. Electric motor vehicle according to one of the preceding claims, **characterized in that** a dome-shaped lighting segment field cover (20) which engages over the lighting segment field (12) and through which light from the lighting segments (10) can pass is provided.

4. Electric motor vehicle according to one of the preceding claims, **characterized in that** the lighting segments (10) of the lighting segment field (12) are each formed by a lighting unit, wherein the lighting units are designed to respectively light up in different colors.

5. Electric motor vehicle according to one of the preceding claims, **characterized in that** a transmitter unit (22) which is connected to the display control device (8) and a mobile display device (24) are provided, wherein the transmitter unit (22) is designed to wirelessly couple the display device (24), and the display device (24) is designed to display the accumulator charge state information item and/or the vehicle operating state information item.

6. Electric motor vehicle according to one of the preceding claims, **characterized in that** the display control device (8) is designed to actuate the lighting segments (10) in such a way that the lighting segment field (12) displays a selection of the longitudinal direction of travel for the electric motor vehicle (1) as a vehicle operating state information item.

7. Electric motor vehicle according to one of the preceding claims, **characterized in that** the display control device (8) is designed to actuate the lighting segments (10) in such a way that the lighting segment field (12) displays an ongoing charging process of the accumulator (4) as an accumulator charge state information item.

## Revendications

1. Véhicule électrique ayant un moteur électrique de traction, un accumulateur d'accumulation d'énergie électrique pour faire fonctionner le moteur électrique de traction, un dispositif d'affichage visuel ayant une multiplicité de segments lumineux pouvant être excités individuellement, **caractérisé en ce que** les segments (10) lumineux sont disposés en formant un champ (12) de segments lumineux, au moins en deux dimensions et rayonnant de la lumière vers le haut dans la direction verticale, le champ (12) de segments lumineux étant, rapporté à la largeur du véhicule, disposés au milieu d'un tableau (18) de bord du véhicule (1) électrique et **en ce que** l'appareil (8) de commande de l'affichage est constitué pour exciter les segments (10) lumineux du champ (12) de segments lumineux, de manière à ce que le champ (12) de segments lumineux donne une information non numérique sur l'état de charge de l'accumulateur et/ou une information non numérique sur l'état de fonctionnement du véhicule.

2. Véhicule électrique suivant la revendication 1, **caractérisé en ce que** le champ (12) de segments lumineux a la forme d'une matrice.

3. Véhicule électrique suivant l'une des revendications précédentes, **caractérisé en ce qu'**il est prévu un recouvrement (20) du champ de segments lumineux en forme de calotte, qui empiète sur le champ (12) de segments lumineux et qui peut être éclairé par transparence par les segments (10) lumineux.

4. Véhicule électrique suivant l'une des revendications précédentes, **caractérisé en ce que** les segments (10) lumineux du champ (12) de segments lumineux sont formés de respectivement une unité lumineuse, les unités lumineuses étant constituées pour éclairer respectivement dans des couleurs différentes.

5. Véhicule électrique suivant l'une des revendications précédentes, **caractérisé en ce qu'**il est prévu une unité (22) d'émission, reliée à l'appareil (8) de commande de l'affichage, et un appareil (24) d'affichage mobile, l'unité (22) d'émission étant constituée pour un couplage sans fil de l'appareil (24) d'affichage et l'appareil (24) d'affichage étant constitué pour un affichage de l'information d'état de charge de l'accumulateur et/ou de l'information de l'état de fonctionnement du véhicule.

6. Véhicule électrique suivant l'une des revendications précédentes, **caractérisé en ce que** l'appareil (8) de commande de l'affichage est constitué pour exciter les segments (10) lumineux, de manière à ce que le champ (12) de segments lumineux affiche, comme information d'état du fonctionnement du véhicule, un choix de direction de marche du véhicule (1) électrique.

7. Véhicule électrique suivant l'une des revendications précédentes, **caractérisé en ce que** l'appareil (8) de commande de l'affichage est constitué pour exciter les segments (10) lumineux, de manière à ce que le champ (12) de segments lumineux indique, comme information d'état de charge de l'accumulateur, une opération de charge en cours de l'accumulateur (4).
